# EUROPEAN PATENT APPLICATION

(11) **EP 4 757 525 A1**
(43) Date of publication of application: **10.06.2026**
(21) Application number: 25220011.8
(22) Date of filing: 02.12.2025
(51) Int. Cl.: H10D 1/00, H10D 1/66, H10W 10/50, H10W 20/00, H10W 10/00

(54) **MANUFACTURING METHOD OF A SEMICONDUCTOR DIE AND SEMICONDUCTOR DIE INTEGRATING A DTI STRUCTURE AND A PILLAR CAPACITOR**

(30) Priority: 05.12.2024 IT 202400027624
(71) Applicant: STMicroelectronics International N.V., 1228 Plan-les-Ouates, Geneva (CH)
(72) Inventor: BASSO, Michele, 20864 AGRATE BRIANZA (MB) (IT); MILANI, Antonella, 20864 AGRATE BRIANZA (MB) (IT); BRAZZELLI, Daniela, 20864 AGRATE BRIANZA (MB) (IT)
(74) Representative: Studio Torta S.p.A.

(57) **Abstract**

Method for manufacturing a semiconductor die (1), comprising the steps of: arranging a semiconductor body (2) having a front side (2a) and a back side (2b) opposite to each other; concurrently forming, through part of the semiconductor body (2), a first trench (6) and a second trench (8), having respective side walls (6a, 8a) and bottom wall (6b, 8b); forming, at the side walls (6a) and the bottom wall (6b) of the first trench (6), a first insulation layer (12) having a first thickness (t1); forming, at the side walls (8a) and the bottom wall (8b) of the second trench (8), a second insulation layer (26) having a respective second thickness (t4) lower than the first thickness (t1); and filling the first and the second trenches (6, 8) with a conductive material layer (32).

## Description

### TECHNICAL FIELD

The present invention relates to a manufacturing method of a semiconductor die and to a semiconductor die integrating a DTI structure and a pillar capacitor.

### PRIOR ART

The use of column capacitors or pillar capacitors is known in the state of the art. A pillar capacitor is formed by an etch process of a semiconductor substrate leading to the formation of vertical pillars in the substrate. The structure of a pillar capacitor offers higher capacitance density, thus enabling the production of devices with high capacitance. The use of capacitors with high capacitance is required in certain applications, such as for example DC-DC converters.

Furthermore, substrate-integrated pillar capacitors do not require the use of a large area for routing bias signals and allow to overcome the need for integrating capacitors in levels higher than the substrate, for example in the package or in the PCB, thus saving production costs.

The Applicant has verified, however, that the concurrent formation, on a same wafer or die, of pillar capacitors and Deep Trench Isolation (so-called DTI) structures requires, in the current state of the art, separate manufacturing steps. This leads to a general increase in costs and manufacturing time used.

The need is therefore felt to overcome these drawbacks, providing a manufacturing method wherein the formation of a pillar capacitor and a deep isolation trench, on a same wafer or die, may be performed minimizing costs and times.

Patent application CN118016593A describes a semiconductor structure and a method for its preparation, which allows the simultaneous formation of two different types of DTI trenches on a single device. One DTI structure is insulating, while the other is conductive for leakage current management.

Patent application US2019/096744A1 describes a semiconductor integrated circuit having a double trench configuration for isolating high-voltage and low-voltage transistors.

However, the aforementioned drawbacks are not overcome.The aim of the present invention is therefore to provide a manufacturing method of a semiconductor die and a semiconductor die, to overcome the disadvantages of the prior art.

### SUMMARY OF THE INVENTION

According to the present invention, a manufacturing method of a semiconductor die and a semiconductor die are provided, as defined in the attached claims.

### BRIEF DESCRIPTION OF THE DRAWINGS

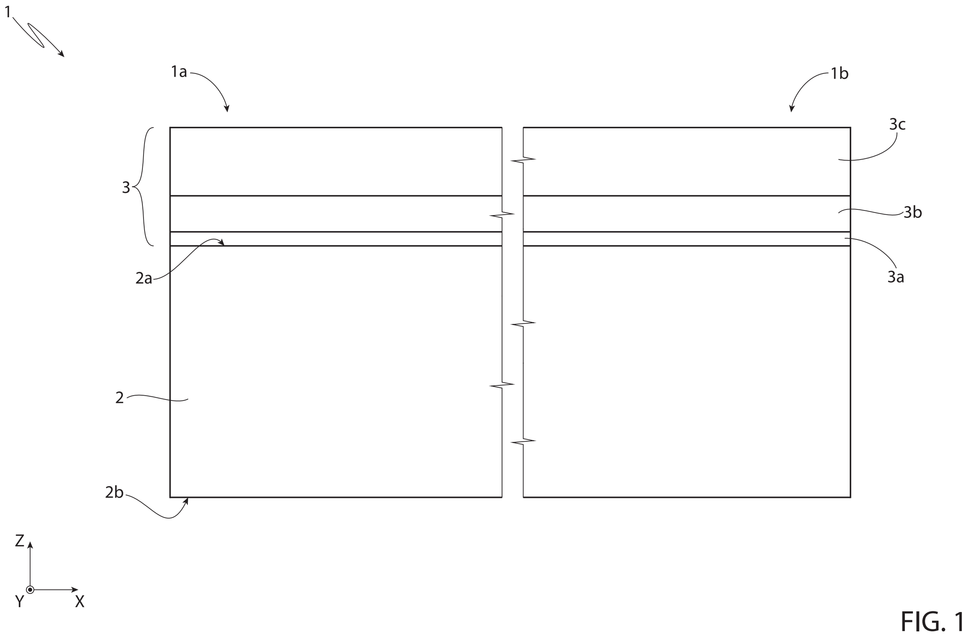

For a better understanding of the present invention, preferred embodiments thereof will now be described, purely by way of non-limiting example, with reference to the attached drawings, wherein Figures 1-10 illustrate manufacturing steps of a die, or wafer, which accommodates a DTI structure and a pillar capacitor.

### DETAILED DESCRIPTION OF THE INVENTION

Figures 1-10 illustrate, in a sectional view in a triaxial reference system, of axes X, Y, Z orthogonal to each other, a portion of a die, or wafer, 1 in respective manufacturing steps thereof. In the following, reference will be made to a die 1 without thereby losing generality.

With reference to Figure 1, the die 1 (in a single piece) includes a first region 1a and a second region 1b. The first region 1a is intended to accommodate, at the end of the manufacturing steps, a deep trench isolation structure, also known as DTI ("Deep Trench Isolation"). The second region 1b is intended to accommodate, at the end of the manufacturing steps, a pillar-type capacitor or columnar capacitor. As evident from the following description, advantageously, the manufacturing of the deep isolation trench in the region 1a and the manufacturing of the pillar capacitor in the region 1b share several process steps, allowing for saving in terms of both manufacturing time and costs.

Again with reference to Figure 1, the die 1 comprises a semiconductor body 2 including a substrate and optionally one or more epitaxial layers (not illustrated in detail) on the substrate. The semiconductor body 2 is for example of silicon or silicon carbide, or gallium nitride or another semiconductor material, of the SOI type. Furthermore, the semiconductor body 2 has a first electrical conductivity type, in particular of the N-type (alternatively of the P-type), with a dopant concentration, for example, between 1·10¹² and 5·10¹⁹ atoms/cm³ (boundaries included), preferably between 1·10¹³ and 5·10¹⁶ atoms/cm³ (boundaries included) .

The semiconductor body 2 has an upper side, or front side, 2a and a lower side, or bottom side, 2b; the upper side 2a and the lower side 2b are substantially parallel to each other and opposite to each other along the Z-axis.

On the upper side 2a extends a layer stack 3, which, in the context of the present invention, has the function of a hard mask for manufacturing steps of the pillar capacitor and the deep isolation trench. However, it is evident that one or more of the layers of the stack 3 may perform further functions in other regions of the die 1, or even within the same regions 1a and 1b (in portions of the latter which are not illustrated in the Figures and which are not part of the present invention).

In the embodiment described and illustrated herein, the stack 3 comprises: a first mask layer 3a, which extends on the upper surface 2a of the semiconductor body, in particular in direct contact with the semiconductor body 2; a second mask layer 3b, which extends on the first mask layer 3a, in particular in direct contact with the first mask layer 3a; and a third mask layer 3c, which extends on the second mask layer 3b, in particular in direct contact with the second mask layer 3b.

The first mask layer 3a is of a first insulating material, for example chosen from among: silicon oxide (SiO₂), silicon nitride (SiN, Si₂N₃), tetraethyl orthosilicate (TEOS), masks so-called "ashable hard masks" (AHMs) formed by an amorphous layer of carbon and polysilicon; the second mask layer 3b is of a material which may be selectively etched with respect to the material of the first mask layer 3a, for example of polysilicon (in particular undoped polysilicon); the third mask layer 3c is of a second insulating material, in particular different from the first insulating material, for example chosen from among: silicon oxide (SiO₂), tetraethyl orthosilicate (TEOS), silicon nitride (SiN, Si₂N₃).

It is evident that the stack 3 may comprise a number of layers lower than three, for example only two layers (the first mask layer 3a and the second mask layer 3b, or the second mask layer 3b and the third mask layer 3c); alternatively, the stack 3 may be replaced by a single layer, chosen from one of the layers 3a-3c mentioned above. Alternatively, the stack 3 might comprise four or more layers.

The steps which lead to the formation of the die 1 of Figure 1 are known per se and are therefore not described in detail. In general and merely by way of example, starting from the semiconductor body 2, the formation of the first mask layer 3a comprises depositing the respective insulating material on the upper surface 2a with CVD (Chemical Vapor Deposition) or sputtering or vapor-phase deposition (PVD) technique, or thermal growth of an oxide of the material of the semiconductor body 2; the formation of the second mask layer 3b comprises depositing the respective material on the first mask layer 3a with CVD or sputtering or PVD technique; the formation of the third mask layer 3c comprises depositing the respective material on the second mask layer 3b with CVD or sputtering or PVD technique, or thermal growth of an oxide of the material of the second mask layer.

Exemplarily, the stack 3 has a total thickness, along the Z-axis, comprised between 0.25 and 7 µm (boundaries included). The first mask layer 3a has a thickness comprised between 10 and 300 nm (boundaries included); the second mask layer 3b has a thickness comprised between 0.2 and 1.5 µm (boundaries included); the third mask layer 3c has a thickness comprised between 0.02 and 2 µm (boundaries included).

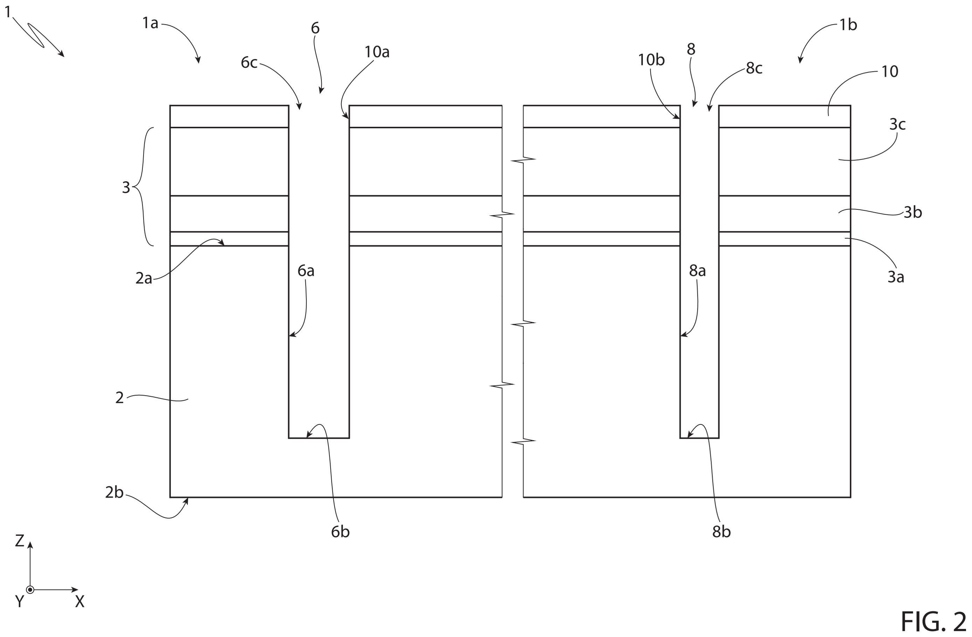

With reference to Figure 2, a first trench 6 in the region 1a and a second trench 8 in the region 1b of the die 1 are formed.

The first trench 6 is designed to form, at the end of the manufacturing process, the DTI structure; the second trench 8 is designed to accommodate, at the end of the manufacturing process, the pillar capacitor.

The formation of the trenches 6 and 8 comprises forming a first etch mask 10 (e.g. of photoresist) on the stack 3 (in particular, on the third insulating layer 3c). The first etch mask 10 is patterned photolithographically so as to form a first aperture 10a which extends completely through the first etch mask 10 in the first region 1a, and a second aperture 10b which extends completely through the first etch mask 10 in the second region 1b.

The first aperture 10a has shape and dimensions equal to those desired for the first trench 6 (it should be noted that, as a function of the successive processing steps, the dimension of the trench 6 might vary during the manufacturing of the same, in particular it might enlarge). For example, the aperture 10a may have a shape which is circular, rectangular, rectangular with rounded edges, oval, or generically polygonal, for example with an extension along the X-axis comprised between 1 and 4 µm, and an extension along the Y-axis greater than the extension along the X-axis and chosen based on design needs (dimension of the die 1, amplitude of the region to be electrically insulated by DTI, etc.), as evident to the person skilled in the art. By way of non-limiting example, the extension along the Y-axis of the first trench 6 is comprised between 5 µm and 3 mm.

The second aperture 10b has shape and dimensions equal to those desired for the second trench 8. For example, the aperture 10b may have a shape which is circular, quadrangular, quadrangular with rounded edges, oval, or generically polygonal, for example with respective extensions along the X-axis and along the Y-axis comprised between 50 nm and 1.5 µm and between 2 µm and 3 mm respectively, and in any case chosen based on the design needs of the pillar capacitor (voltage class, low-power or high-power application, etc.), as is evident to the person skilled in the art.

Then, using the first etch mask 10, one or more etchings are carried out for removing the layers 3a-3c which form the stack 3, and part of the semiconductor body 2. In particular, there are performed one or more RIE ("Reactive Ion Etching") etchings, using suitable etch chemistries as a function of the materials of the stack 3 to be removed, and a successive anisotropic deep etching, e.g. DRIE (Deep Reactive Ion Etching) to etch the semiconductor body 2 along the Z-axis, until the intended depth. For example, the respective depths of the first and the second trenches 6, 8, along the Z-axis starting from the upper surface 2a, are comprised between 10 and 40 µm. The respective depths of the trenches 6 and 8 may be equal to each other (except for negligible variations intrinsically due to the manufacturing process of the same) or different from each other. For example, as a function the material removal technique used, the depth of the trenches 6, 8 may depend on the dimension of the opening 6c, 8c of the trenches 6, 8, so that, although the etching to form the trenches 6, 8 occurs concurrently for both trenches 6 and 8, the respective depths might not be equal to each other. The etch rate in fact depends on the dimension (on the XY plane) of the trench, and is higher in trenches having a greater opening dimension (on the XY plane); therefore, for the same etch time, a trench having an opening with greater dimension will be able to have a depth (along the Z-axis) greater than a trench having an opening with smaller dimension. In the case of the invention described, by forming the opening 6c with a dimension (area, on the XY plane) greater than the opening 8c, the first trench 6 will be obtained with a depth (in the substrate 2, along the Z-axis) greater than the respective depth of the second trench 8.

In an optional embodiment, any polymeric by-products which form during the etch steps are expelled and moved away from the structure being defined by appropriate choice of pressure and flow of the etch gases, so that they do not deposit on the walls of the trenches thus formed. The removal of any by-products of the etching may also occur by washing steps, as is evident to the person skilled in the art.

The first and the second trenches 6, 8 are thus formed, which extend completely through the stack 3 (i.e., through the insulating layers 3a-3c) and partially through the semiconductor body 2, extending from the upper surface 2a towards the lower surface 2b and ending within the semiconductor body 2, at a distance from the lower surface 2b.

The first trench 6 has side walls 6a, a bottom 6b and an opening 6c. The opening 6c of the first trench 6 is at the stack 3 (in particular at the insulating layer 3c), while the bottom 6b is within the semiconductor body 2.

The second trench 8 has side walls 8a, a bottom 8b and an opening 8c. The opening 8c of the second trench 8 is at the stack 3 (in particular at the insulating layer 3c), while the bottom 8b is within the semiconductor body 2.

The side walls 6a and 8a of both the first and the second trenches 6, 8 extend substantially along the direction of the Z-axis. "Substantially" means that, in a view with electron microscope, the side walls 6a, 8a may not be, locally, perfectly aligned with the Z-axis but, as a whole, extend along, or approximating, a straight line parallel to the Z-axis. The bottom 6b, 8b of both the first and the second trenches 6, 8 lies on the XY plane or substantially on the XY plane (i.e., unless there are local discrepancies resulting from the manufacturing process).

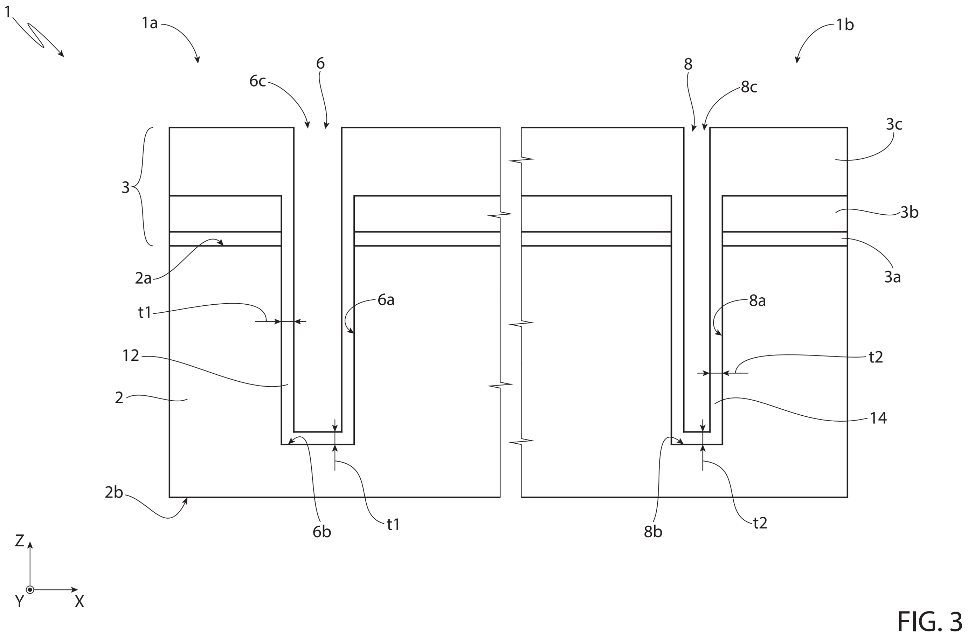

Subsequently, Figure 3, the first etch mask 10 is removed. A formation step of an insulation layer 12 within the first trench 6 and of a respective insulation layer 14 within the second trench 8 is then performed, during a same growth or deposition step. The insulation layer 12 in the first trench 6 completely covers the side walls 6a and the bottom 6b of the first trench 6. The insulation layer 14 in the second trench 8 completely covers the side walls 8a and the bottom 8b of the second trench 8. The insulation layers 12, 14 are, in one embodiment, grown by a thermal oxidation process of the portions of semiconductor body 2 exposed through the trenches 6, 8 (in this case, the insulation layers 12, 14 are of an oxide of the material of the semiconductor body, for example SiO₂), or may be deposited by CVD or sputtering or PVD technique (e.g. by depositing or growing SiO₂, TEOS, SiN or other insulating material).

The insulation layer 12 in the first trench 12 and the insulation layer 14 in the second trench 8 have a respective thickness t1, t2 substantially equal to each other (unless there are non-significant variations due intrinsically to the formation process of the same), for example comprised between 0.1 and 2 µm.

In the trenches 6 and 8, the thickness t1, t2 at the side walls 6a, 8a is measured along the X-axis, while the thickness t1, t2 at the bottom 6b, 8b is measured along the Z-axis. Based on the process chosen for the formation of the insulating layers 12 and 14, the respective thicknesses t1, t2 at the side walls 6a, 8a may be different from the respective thicknesses t1, t2 at the bottom 6b, 8b. In one embodiment, the insulation layers 12, 14 have respective thicknesses t1, t2, which are uniform both along the side walls 6a, 8a and at the bottom 6b, 8b.

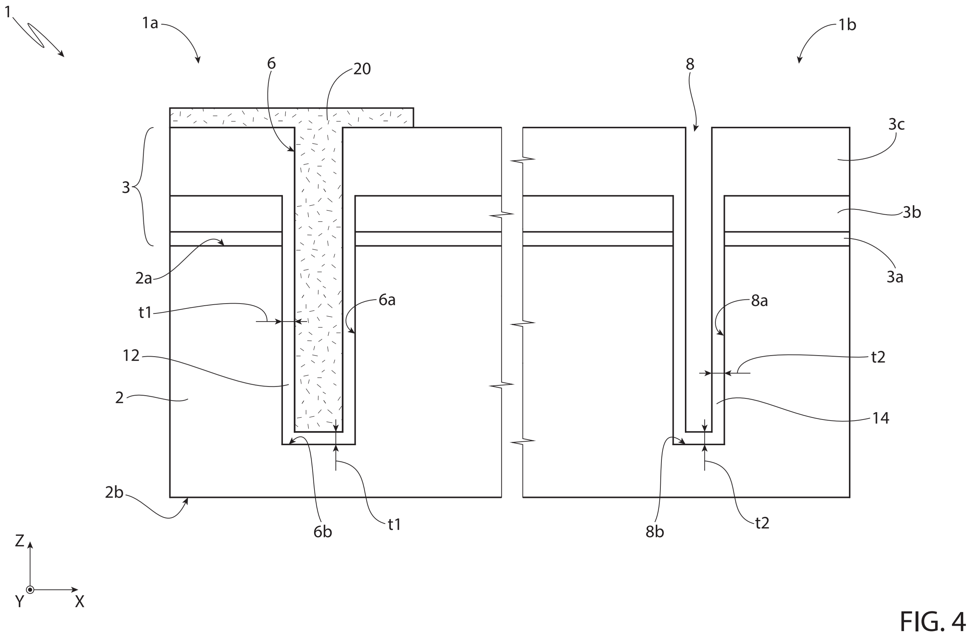

Subsequently, Figure 4, the method proceeds with a formation step of a second etch mask 20, by a deposition step of a suitable material. For example, polymeric material, in particular photoresist, is deposited above the stack 3 and within the first and the second trenches 6, 8. According to a non-limiting aspect of the present invention, the formation of the second etch mask 20 comprises the complete filling of at least the first trench 6 with photoresist. The second etch mask 20 also completely or partially fills the second trench 8. This step entails the formation of a layer of photoresist also above the die 1, i.e. above the stack 3. This layer may be thinned, if necessary and suitable.

The method then proceeds with a patterning step of the second etch mask 20, to remove it completely from the second region 1b, but not from the first region 1a, of the die 1. For example, in the case of negative photoresist, a photoexposure step of the second etch mask 20 is envisaged, protecting the second region 1b, for the complete reticulation of the portion of the second etch mask 20 extending in the first region 1a, above the first trench 6. Vice versa, in the case of positive photoresist.

The method then proceeds with an etch step (e.g., a bath in a solvent solution) to remove the second etch mask 20 from the second region 1b and in general from the surface of the die 1, except for the first region 1a which accommodates the first trench 6. The second etch mask 20 may thus be eliminated from the surface of the die 1, leaving unchanged the portion of the second etch mask 20 which fills the first trench 6.

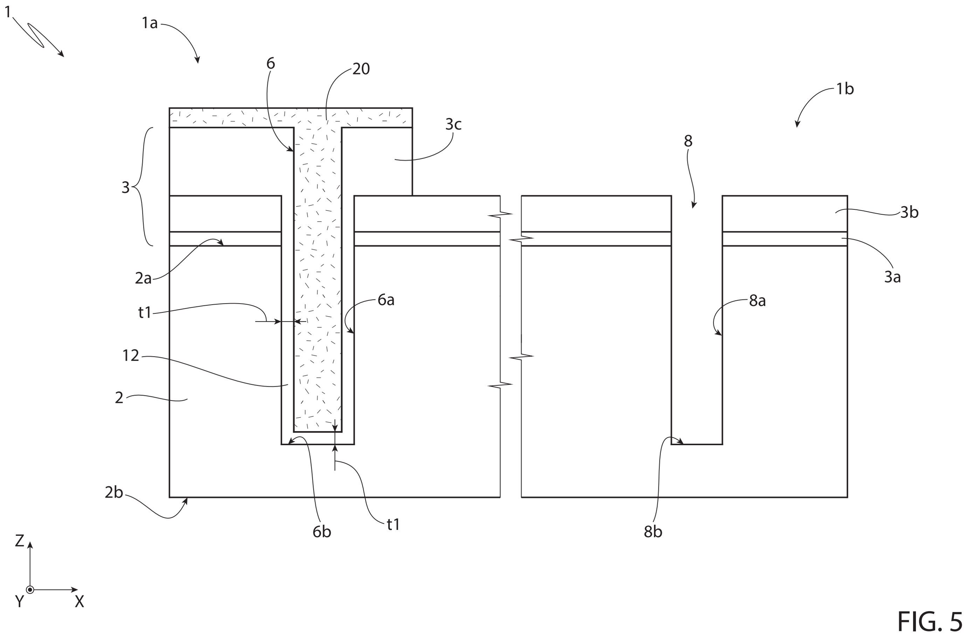

Then, Figure 5, the third mask layer 3c is etched, for example by anisotropic dry etching (which is selective with respect to the previously deposited oxide), in particular in the case of TEOS using an etch chemistry based on CF₄/CHF₃ by RIE plasma. The etching of Figure 5 stops at the surface of the second mask layer 3b, which in this context functions as an etch stop layer. The etching of the third mask layer 3c is therefore a masked etching, wherein the second etch mask 20 has been previously patterned so as to protect the first trench 6. Since, as mentioned, the second etch mask 20 is not present in the second region 1b at the second trench 8, the etching of Figure 5 completely removes the third mask layer 3c in the second region 1b and in particular above the second trench 8. Furthermore, since the insulation layer 14 which extends in the second trench 8 is of silicon oxide, this etching concurrently and completely removes also the insulation layer 14, exposing the semiconductor body 2 at the side 8a and bottom 8b walls of the second trench 14. In case the third mask layer 3c and the insulation layer 14 are of two materials not removable with a same etch chemistry, two successive etchings are performed with respective and suitable etch chemistries.

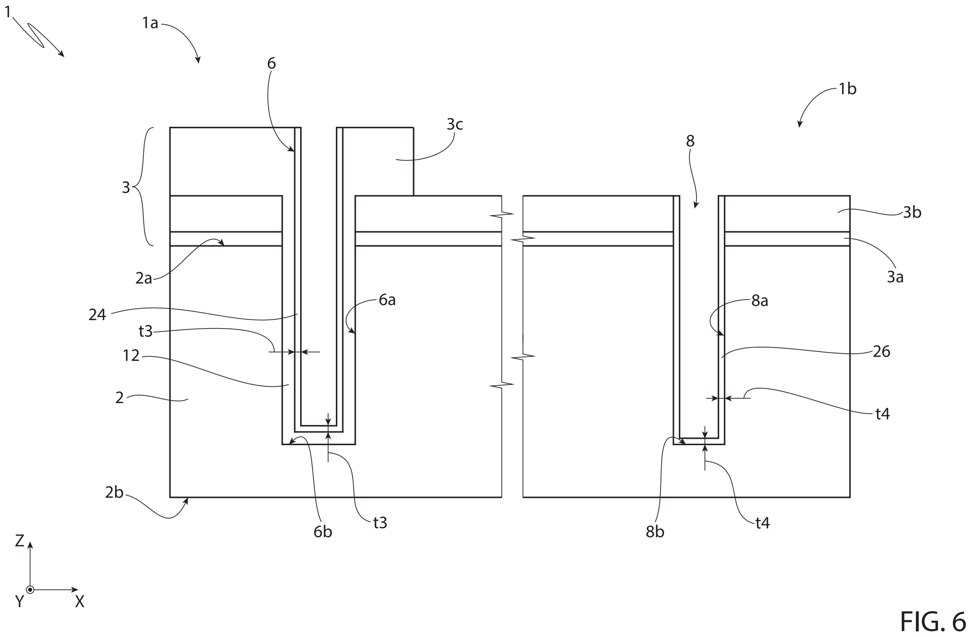

Then, Figure 6, the second etch mask 20 is completely removed from the die 1, i.e. completely removed from the region 1a and from within the first trench 6. The insulation layer 12 remains within the first trench 6, along the side walls 6a and the bottom 6b of the first trench 6, covering them completely and with physical continuity. The third mask layer 3c also remains above the die 1.

Then, again with reference to Figure 6, a formation step of a further insulation layer 24 within the first trench 6 and of a further insulation layer 26 within the second trench 8 is performed. This step comprises, for example, a thermal growth of an oxide of the material of the semiconductor body 2 (e.g., silicon oxide - SiO₂) or a deposition step of insulating material, for example by CVD or sputtering or ALD. The insulation layer 24 is additional with respect to the insulation layer 12, and in particular covers the exposed surface of the insulation layer 12 in the first trench 6. The insulation layer 26 extends with physical continuity along the side walls 8a and the bottom 8b of the second trench 8, completely covering the side walls 8a and the bottom 8b of the second trench 8. Consequently, within the second trench 8, the semiconductor body 2 is completely electrically insulated by the insulation layer 26.

The insulation layer 24 has a thickness t3 which is lower than the thickness t1 of the insulation layer 12, both along the X-axis at the side walls 6a and along the Z-axis at the bottom 6b. In particular, the thickness t3 along the X-axis at the side walls 6a and along the Z-axis at the bottom 6b is comprised between 1 nm and 30 nm (boundaries included). The value of t3 is, in any case, dependent on the desired voltage withstanding, the values mentioned refer to an example wherein the voltage withstanding range varies between 1 and 10 V. The thickness t3 along the X-axis at the side walls 6a may have the same value, or a different value, with respect to the thickness t3 along the Z-axis at the bottom 6b.

The insulation layer 26 has a thickness t4 which is lower than the thickness t2 of the insulation layer 14, both along the X-axis at the side walls 8a and along the Z-axis at the bottom 8b. In particular, the thickness t4 along the X-axis at the side walls 8a and along the Z-axis at the bottom 8b is comprised between 1 nm and 30 nm (boundaries included). As previously observed for t3, the value of t4 is also dependent on the desired voltage withstanding, the values mentioned refer to an example wherein the voltage withstanding range varies between 1 and 10 V. The thickness t4 along the X-axis at the side walls 8a may have the same value, or a different value, with respect to the thickness t4 along the Z-axis at the bottom 8b.

In a non-limiting embodiment of the present invention, as a function of the formation process of the insulation layers 24, 26, the values of t3 and t4 are equal to each other. In a further non-limiting embodiment of the present invention, as a function of the formation process of the insulation layers 24, 26, the values of t3 and t4 are different from each other.

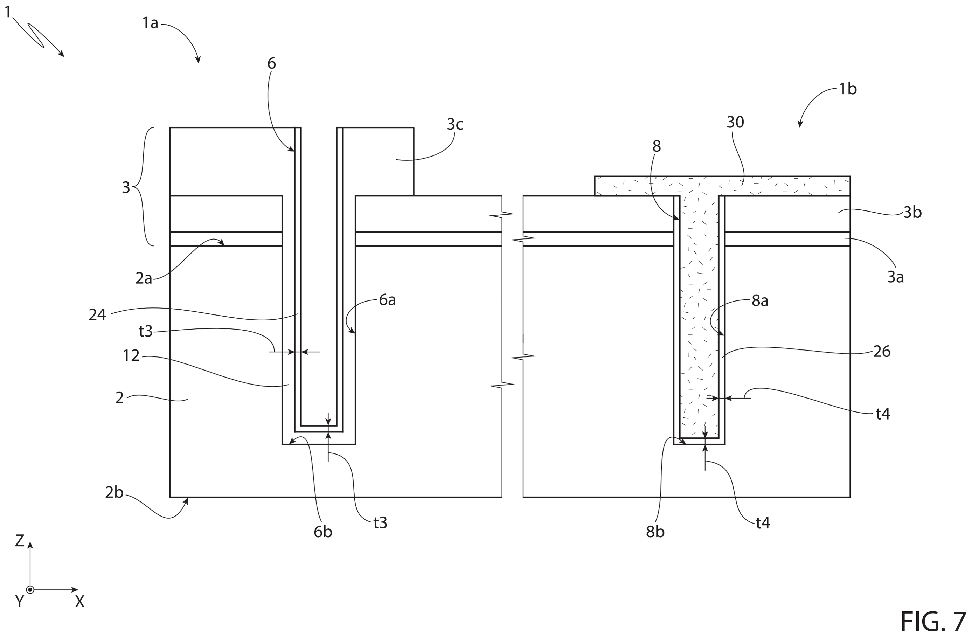

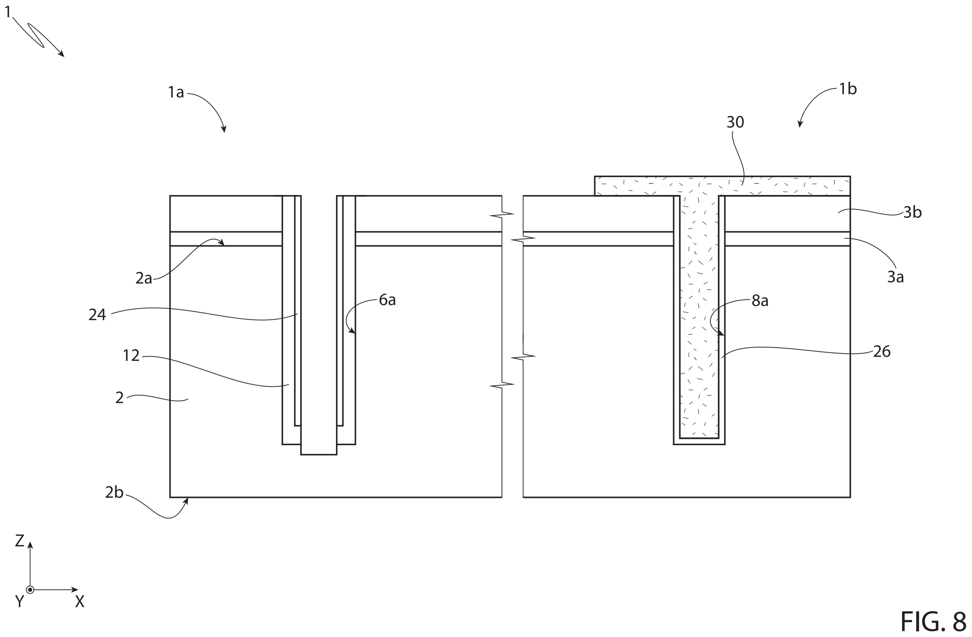

The steps described hereinbelow with reference to Figures 7 and 8 relate to the removal of the insulation layers 12 and 24 from the bottom 6b of the trench 6. These steps of Figures 7 and 8 are optional, since the removal of the insulation layers 12 and 24 from the bottom 6b of the trench 6 may be omitted.

Subsequently, Figure 7, a formation step of a third etch mask 30 is performed on the die 1, by a deposition step of a suitable material. For example, polymeric material, in particular photoresist, is deposited above the die 1 and within the first and the second trenches 6, 8. According to a non-limiting aspect of the present invention, the formation of the third etch mask 30, for example through deposition of the photoresist, comprises the complete filling of at least the second trench 8. The third etch mask 30 also completely or partially fills the first trench 6. This step entails the formation of a thick layer of photoresist also above the third mask layer 3c in the first region 1a and above the second mask layer 3b in the second region 1b. This thick layer of photoresist may be, if necessary and suitable, partially removed to reduce its thickness.

The method then proceeds with a patterning step of the third etch mask 30, to remove it completely from the first region 1a, but not from the second region 1b, of the die 1. For example, in the case of negative photoresist, a photoexposure step of the third etch mask 30 is envisaged, protecting the first region 1a, for the complete reticulation of the photoresist layer extending in the second region 1b, above the second trench 8. Vice versa, in the case of positive photoresist.

The method then proceeds with an etch step (e.g., a bath in a solvent solution) to remove the mask layer 30 from the first region 1a and in general from the surface of the die 1 except for the second region 1b which accommodates the second trench 8. The third etch mask 30 may thus be eliminated from the surface of the die 1, leaving unchanged the portion of the third etch mask 30 which fills the second trench 8.

Then, Figure 8, the third mask layer 3c is etched by anisotropic dry etching, for example in the case of TEOS using an etch chemistry based on CF₄/CHF₃ by RIE plasma, to completely remove the third mask layer 3c from the first region 1a. The anisotropic etching proceeds along the Z-axis. In this same etch step, according to an aspect of the present invention, the insulation layers 12, 24 are also etched and partially removed. In fact, in case the insulation layers 12, 24 are of silicon oxide and the third mask layer is of TEOS or silicon oxide, the etch chemistry used to remove the third mask layer 3c also removes the insulation layers 12, 24. Since, as mentioned, the etching is of the anisotropic type, the insulation layers 12, 24 are removed exclusively from the bottom 6b of the first trench 6, and not also from the side walls 6a of the same.

The etching proceeds until the third mask layer 3c and the insulation layers 12 and 24 on the bottom 6b of the first trench 6 are completely removed, in order to expose a respective portion of the semiconductor body 2 through the bottom 6b of the trench 6.

As previously mentioned, in one embodiment, the removal of the insulation layers 12 and 14 from the bottom 6c of the first trench 6 may be omitted. In this case, the insulation layers 12 and 24 electrically insulate the inside of the first trench 6 from the substrate 2.

It is noted that a possible partial or total removal of the third mask layer 24, and/or a partial removal of the first mask layer 12 underlying, does not compromise the present invention. Such removal, possible but not desired, may occur as a result of a non-optimal anisotropicity of the etching described above (which for example proceeds preferentially, but not exclusively, along the direction of the Z-axis).

The etching of Figure 8 stops at the surface of the second mask layer 3b, which in this context functions as an etch stop layer.

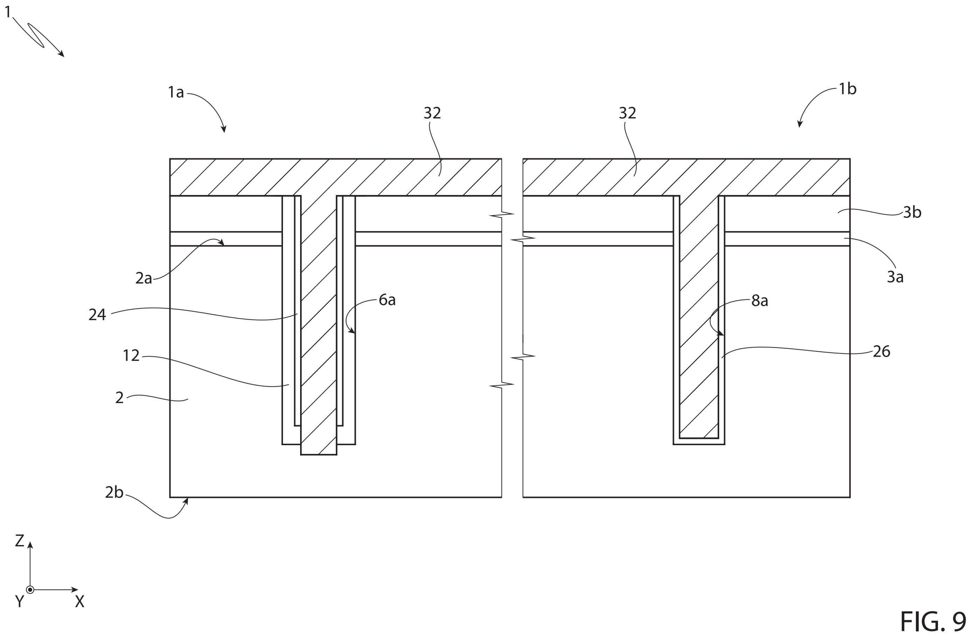

Then, Figure 9, the third etch mask 30 is completely removed from the die 1, i.e. completely removed from the second region 1b and from within the second trench 8. The insulation layer 26 remains within the second trench 8, along the side walls 8a and the bottom 8b of the second trench 8, covering them completely and with physical continuity.

Finally, a formation step (e.g., a deposition step) of a conductive layer 32, for example of metal or doped polysilicon (e.g., with P-type conductivity and doping of the order of 10¹⁸-10²¹ at/cm³), is performed on the die 1 and in particular within the first trench 6 and the second trench 8. In case the substrate 2 is P-type doped, the conductive layer 32 is of metal or N-type doped polysilicon.

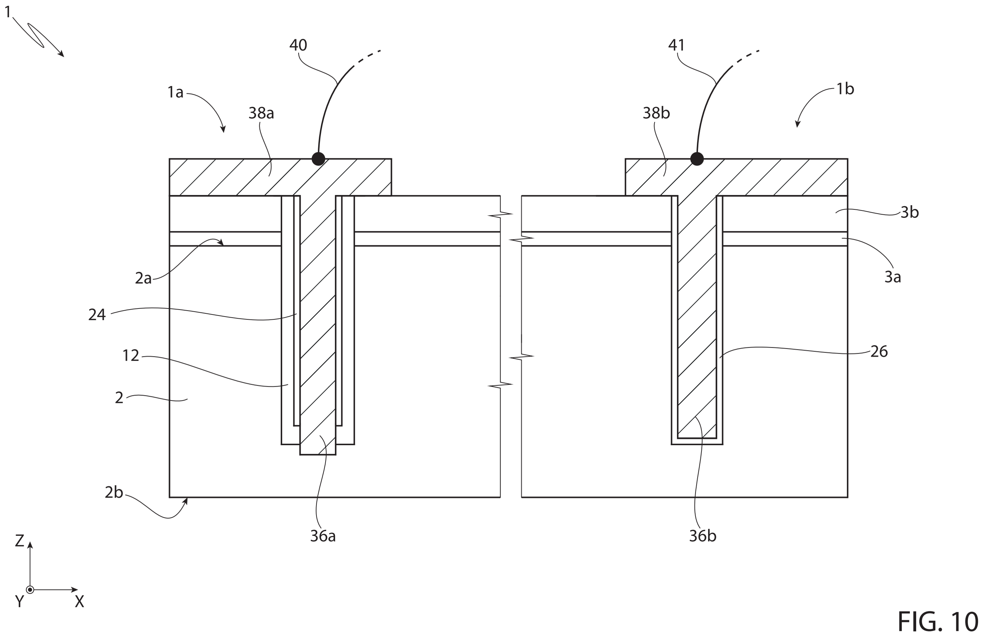

The conductive layer 32 extends in the first trench 6 (portion 36a in Figure 10) until reaching and electrically contacting the semiconductor body 2 at the bottom 6b; more in particular, the conductive layer 32 extends with electrical continuity between the semiconductor body 2 at the bottom 6b and the opening 6c of the first trench 6. The conductive layer 32 may completely or only partially fill the first trench 6 (while ensuring electrical contact with the semiconductor body 2 at the bottom 6b and electrical continuity until the opening 6c).

The conductive layer 32 also extends in the second trench 8 (portion 36b in Figure 10), completely covering the fourth insulating layer 26 at the side walls 8a and the bottom 8b of the second trench 8; more in particular, the conductive layer 32 extends with electrical continuity for the entire extension of the fourth insulating layer 26, both at the side walls 8a and the bottom 8b, until reaching the opening 8c of the second trench 8.

The conductive layer 32 may completely or only partially fill the second trench 8 (e.g., extending with physical and electrical continuity along the side walls 8a and the bottom 8b). The portion 36a of the conductive layer 32 which extends in the first trench 6 is electrically insulated from the portion 36b of the conductive layer 32 which extends in the second trench 8. This electrical insulation is obtained by suitably patterning the conductive layer 32 above the die 1, to form conductive paths 38a, 38b which are separate from each other.

In the case of the pillar capacitor formed in the second trench 8, it is noted that a first electrode of the capacitor is formed by the semiconductor body 2 and a second electrode of the capacitor is formed by the conductive layer 32 in the second trench 8.

In one embodiment, as illustrated in Figure 10, the conductive layer 32 above the die 1, on the second mask layer 3b, is not completely removed. In particular, the conductive layer 32, above the die 1, is patterned in such a way as to define at least a first conductive path 38a in electrical contact with the portion 36a of conductive layer 32 within the first trench 6 and at least a second conductive path 38b in electrical contact with the portion 36b of conductive layer 32 within the second trench 8. Electrical connections 40, 41 may be envisaged (e.g., wire bonding, solder bonding, etc.) in contact with the first and the second conductive paths 38a, 38b, respectively. Alternatively, in the case of integrated circuits, the method proceeds with the connection through a contact at the first available routing metal level.

In a further embodiment, the conductive layer 32 does not extend above the die 1. In this case, the electrical connection with the respective portions of conductive layer 32 within the first and the second trenches 6 and 8 is provided by wire bonding, or by solder ball or other element adapted to form an electrical contact directly with the conductive material within the respective trench 6, 8. Alternatively, in the case of integrated circuits, the method proceeds with the connection through a contact at the first available routing metal level.

The aforementioned DTI in the region 1a and the pillar capacitor in the region 1b of the same die 1 are thus formed. In a manner not illustrated in the Figure, an electrical insulation ring may be formed (e.g. by implanting P-type dopants, or by forming a deep trench, or by alternating P and N implants) which completely surrounds the pillar capacitor.

Finally, it is clear that modifications and variations may be made to what has been described and illustrated here without thereby departing from the scope of the present invention, as defined in the attached claims.

According to a further embodiment of the present invention, after the step of Figure 2 of forming the trenches 6, 8, a formation step of a mask (similar to the mask 30 of Figure 8) is performed to fill and protect the second trench 8. Then, the formation step of the first insulating layer 12 in the first trench 6 is performed according to what has already been described with reference to Figure 3. In this embodiment, since the second trench 8 is protected, the second insulating layer 14 is not formed which, therefore, does not need to be removed. The method then proceeds with the steps already described of Figures 6-10.

According to a further embodiment of the present invention, the first and the second trenches 6, 8 are not formed concurrently as described with reference to Figure 2, but in separate steps. For example, the first trench 6 is formed (according to the process previously described) and, in the absence of the second trench 8, the first insulating layer 12 is formed, as already described. After the formation of the first insulating layer 12, the second trench 8 is formed (according to the process previously described). The method then proceeds with the steps already described of Figures 6-10.

These alternative embodiments allow the formation step of the second insulating layer 14 in the second trench 8 and the successive removal of the second insulating layer 14 to be avoided.

Furthermore, the present invention may be extended to the manufacture of any type of trench-gate vertical-conduction device, such as, but not limited to, a VDMOS transistor, or a trench-gate power MOSFET device. In this context, the steps described for manufacturing the DTI structure are used to form the trench gate.

Furthermore, a plurality of DTI structures and/or a plurality of pillar capacitors may be manufactured on the same die 1. The same structures may also be used to insulate planar or non-planar components, such as for example Lateral Power MOSFETs, CMOSs, BJTs, JFETs, etc.

## Claims

1. A method for manufacturing a semiconductor die (1), comprising the steps of:
- arranging a semiconductor body (2) having a front side (2a) and a back side (2b) opposite to each other along a direction (Z);
- forming, through part of the semiconductor body (2) along said direction (Z), a first deep trench isolation, DTI, structure, including the sub-steps of:
forming, through part of the semiconductor body (2) along said direction (Z), a first trench (6) having side wall (6a), opening (6c) and bottom wall (6b);
forming, at the side wall (6a) and the bottom wall (6b) of the first trench (6), a first insulation layer (12) having a first thickness (t1) and extending with physical continuity at the side walls (6a) and the bottom wall (6b) of the first trench (6); and
filling the first trench (6) with conductive material (32);
- forming, through part of the semiconductor body (2) along said direction (Z), a pillar capacitor, including the sub-steps of:
forming, through part of the semiconductor body (2) along said direction (Z), a second trench (8) having respective side wall (8a), opening (8c) and bottom wall (8b) ;
forming, at the side wall (8a) and the bottom wall (8b) of the second trench (8), a second insulation layer (26) having a second thickness (t4) lower than the first thickness (t1) and extending with physical continuity at the side walls (8a) and the bottom wall (8b) of the second trench (8); and
filling the second trench (8) with said conductive material (32).

2. The method according to claim 1, wherein a hard mask (3) extends on the front side (2a) of the semiconductor body (2),
the steps of forming the first trench (6) and the second trench (8) comprising forming respective first and second apertures in the hard mask (3) until reaching the front side (2a), and performing a deep etching of the semiconductor body (2) at the first and the second apertures along said direction (Z), ending within the semiconductor body (2).

3. The method according to claim 1 or 2, comprising, concurrently with the step of forming the first insulation layer (12), the step of forming, at the side walls (8a) and at the bottom wall (8b) of the second trench (8), a third insulation layer (14) having a third thickness (t2),
in particular, wherein forming the first and the second insulation layers (12, 14) comprises thermally growing an oxide of the semiconductor material of the semiconductor body (2) or depositing an insulating material.

4. The method according to claim 3, further comprising the step of selectively removing the third insulation layer (14) from the second trench (8) maintaining the first insulation layer (12) through the steps of:
forming a first etch mask (20) within the first and the second trench (6, 8);
completely removing the first etch mask (20) from the second trench (8) completely exposing said second insulation layer (14), maintaining the first etch mask (20) in the first trench (6).

5. The method according to anyone of claims 3-4, further comprising, concurrently with the step of forming the second insulation layer (26), the step of forming, at the side walls (6a) and the bottom wall (6b) of the first trench (6), a fourth insulation layer (24) having a respective fourth thickness (t3) smaller than the first thickness (t1) and the third thickness (t2),
in particular, wherein forming the second and the fourth insulation layers (24, 26) comprises, after the step of selectively removing the third insulation layer (14) from the second trench (8), the step of thermally growing an oxide of the semiconductor material of the semiconductor body (2) or depositing an insulating material in the first and the second trenches (6, 8).

6. The method according to anyone of the preceding claims, wherein the first thickness (t1) is comprised between 0.1 and 2 µm, and the second thickness (t4) is comprised between 1 nm and 30 nm.

7. The method according to any of the preceding claims, further comprising the step of removing selective portions of the first insulation layer (12) at the bottom wall (6b) of the first trench (6) maintaining said physical continuity of the first insulation layer (12) at the side walls (6a) of the first trench (6) and maintaining said physical continuity of the second insulation layer (26) at the side walls (8a) and the bottom wall (8b) of the second trench (8).

8. The method according to claim 7, wherein removing selective portions of the first insulation layer (12) at the bottom wall (6b) of the first trench (6) comprises the steps of:
forming a second etch mask (30) within the first and the second trenches (6, 8);
removing the second etch mask (30) completely from the first trench (6), maintaining the second etch mask (30) within the second trench (8); and
performing an anisotropic etching having a preferential etch direction along said direction (Z), said anisotropic etching being performed until the first insulation layer (12) is completely removed at the bottom wall (6b) of the first trench (6).

9. The method according to anyone of the preceding claims, wherein the semiconductor body has a first electrical conductivity (N; P), the step of filling the first and the second trenches (6, 8) with conductive material (32) comprises depositing doped polysilicon, having a second electrical conductivity (P; N) opposite to the first electrical conductivity (N; P), in the first trench and in the second trench, alternatively depositing metallic material in the first trench and in the second trench.

10. The method according to anyone of claims 3-9 when dependent on claim 2, wherein the hard mask (3) comprises: a first mask layer (3a) on the front side (2a) of the semiconductor body (2), a second mask layer (3b) on the first mask layer (3a), and a third mask layer (3c) on the second mask layer (3b),
and wherein: the first and the third mask layers (3a, 3c) are of respective insulating materials, and the second mask layer (3b) is of a material which may be selectively removed with respect to the material of the third mask layer (3c),
the method further comprising, concurrently with the step of selectively removing the third insulation layer (14) from the second trench (8), the step of removing selective portions of the third mask layer (3c) at the opening (8c) of the second trench (8) using the second mask layer (3b) as an etch stop layer, and
the method further comprising, concurrently with the step of removing selective portions of the first insulation layer (12) at the bottom wall (6b) of the first trench (6), the step of removing selective portions of the third mask layer (3c) at the opening (6c) of the first trench (6) using the second mask layer (3b) as an etch stop layer.

11. A semiconductor die (1), comprising:
- a semiconductor body (2) having a front side (2a) and a back side (2b) opposite to each other along a direction (Z);
- a first deep trench isolation, DTI, structure extending in a first trench (6) through part of the semiconductor body (2) along said direction (Z) and ending within the semiconductor body (2), the first trench (6) having respective side walls (6a), opening (6c) and bottom wall (6b);
- a pillar capacitor extending in a second trench (8) through part of the semiconductor body (2) along said direction (Z), the second trench (8) having respective side walls (8a), opening (8c) and bottom wall (8b);
the first DTI structure comprising: a first insulation layer (12, 24; 12) extending with physical continuity at the side walls (6a) of the first trench (6); and a first conductive filling (36a) extending on the first insulation layer (12, 24; 12) at the side walls (6a) of the first trench (6);
the pillar capacitor comprising: a second insulation layer (26) extending with physical continuity at the side walls (8a) and the bottom wall (8b) of the second trench (8); and a second conductive filling (36b) extending on the second insulation layer (26) at the side walls (8a) and the bottom wall (8b) of the second trench (8), electrically insulated from the semiconductor body (2) by said second insulation layer (26),
wherein a thickness (t4) of the second insulation layer (26) is lower than a respective thickness (t1) of the first insulation layer (12, 24; 12).

12. The semiconductor die according to claim 11, further comprising, at the side wall (6a) and bottom wall (6b) of the first trench (6), a further insulation layer (24) having a respective thickness (t3) less than the first thickness (t1).

13. The semiconductor die according to anyone of claims 11-12, wherein the first thickness (t1) is between 0.1 µm and 2 µm, and the second thickness (t4) is between 1 nm and 30 nm.

14. The semiconductor die according to anyone of claims 11-13, wherein the semiconductor body (2) has a first electrical conductivity (N; P), and wherein the first conductive filling (36a) and the second conductive filling (36b) comprise doped polysilicon having a second electrical conductivity (P; N) opposite to the first electrical conductivity, alternatively metallic material.
